# EUROPEAN PATENT SPECIFICATION

(11) **EP 1 876 651 B1**
(45) Date of publication and mention of the grant of the patent: **13.11.2019**
(21) Application number: 06731542.4
(22) Date of filing: 11.04.2006
(51) Int. Cl.: H01L 31/0224, H01L 31/04, H01L 21/225, H01L 31/18, H01L 31/06, H01L 31/068

(54) **SOLAR CELL MANUFACTURING METHOD**
SOLARZELLEN-HERSTELLUNGSVERFAHREN
PROCEDE DE FABRICATION D' UNE CELLULE SOLAIRE

(30) Priority: 26.04.2005 JP 2005127950
(43) Date of publication of application: 09.01.2008
(73) Proprietor: Shin-Etsu Handotai Co., Ltd., Tokyo (JP); Naoetsu Electronics Co., Ltd., Jyoetu-shi, Niigata 942-0193 (JP); Shin-Etsu Chemical Co., Ltd., Tokyo 100-0004 (JP)
(72) Inventor: OHTSUKA, Hiroyuki, Annaka-shi, Gunma 3790196 (JP); TAKAHASHI, Masatoshi, Annaka-shi, Gunma 3790196 (JP); ISHIKAWA, Naoki, Annaka-shi, Gunma 3790196 (JP); SAISU, Shigenori, Annaka-shi, Gunma 3790196 (JP); UEGURI, Toyohiro, Annaka-shi, Gunma 3790196 (JP); OJIMA, Satoyuki, Annaka-shi, Gunma 3790196 (JP); WATABE, Takenori, Annaka-shi, Gunma 3790196 (JP); AKATSUKA, Takeshi, Jyoetsu-shi, Niigata 9420193 (JP); ONISHI, Tsutomu, Jyoetsu-shi, Niigata 9420193 (JP)
(74) Representative: Wibbelmann, Jobst
(86) International application number: PCT/JP2006/307595
(87) International publication number: WO 2006/117980

(56) References cited:
- WO-A1-00/54341
- WO-A1-96/28851
- JP-A- 01 007 518
- JP-A- 01 205 417
- JP-A- 06 252 428
- JP-A- 10 070 296
- JP-A- 46 001 614
- JP-A- 59 063 741
- JP-A- 63 066 929
- JP-A- 63 260 126
- JP-A- 2000 183 379
- JP-A- 2002 124 692
- JP-A- 2002 539 615
- JP-A- 2003 224 285
- JP-A- 2004 221 149
- JP-A- 2004 221 149
- JP-A- 2004 273 826
- US-A- 4 152 824
- US-B1- 6 552 414
- US-B1- 6 777 729

## Description

### TECHNICAL FIELD

The present invention relates to a method for manufacturing a solar cell according to claim 1.

### BACKGROUND ART

Currently, cost reduction is an important issue for a method that is used for manufacturing solar cells for consumer use, and a method in which a thermal diffusion method and a screen printing method are combined is commonly used. Details thereof are as follows.

First, there is prepared a p-type silicon substrate, which is obtained in such a way that a single crystal silicon ingot pulled up by the Czochralski (CZ) method or a polycrystalline silicon ingot fabricated by the cast method is sliced by the multi-wire method. Next, after removing slice damage on a surface of the substrate with an alkaline solution, fine unevenness (texture) with a maximum height of about 10 micrometers is formed on the surface, and an n-type diffusion layer is formed by a thermal diffusion method. Next, TiO₂ or SiN is deposited about, for example, 70 nm in film thickness on a light-receiving surface to thereby form an antireflection film. A backside electrode is then formed by printing and firing a material mainly composed of aluminum over the whole back surface of the light-receiving surface. Meanwhile, an electrode of the light-receiving surface is formed by printing and firing a material mainly composed of silver into a comb shape with a width of about 100 to 200 micrometers, for example.

Superior points of this technique are that various effects for improving characteristics are included, although it has a minimum necessary number of processes for composing the device. For example, the thermal diffusion serves to improve a diffusion length of a minority carrier within a bulk due to a gettering action. Additionally, the firing of the aluminum layer printed at the backside forms a p⁺ high-concentration layer used as an electric field layer (BSF: Back Surface Field) as well as forms the electrode. Further, the antireflection film reduces a recombination velocity of carriers generated near a silicon surface as well as provides an optical effect (reflectance reduction).

Cost reduction of the solar cell for consumer use has been achieved further than before by the aforementioned minimum necessary number of processes and several useful effects.

According to this technique, however, a significant improvement in conversion efficiency cannot be expected any more. For example, in the solar cell using the silicon single crystal substrate, the conversion efficiency reaches a ceiling at about 16%. The reason is that in order to sufficiently reduce a contact resistance of the electrode of the light-receiving surface, a surface concentration of a dopant, such as phosphorus or the like, in a diffusion layer must be about 2.0 to 3.0x10²⁰ cm⁻². When it is highly concentration in the surface like this, a surface level will become extremely high. Therefore, carrier recombination near the light-receiving surface is facilitated, and a short circuit current and an open circuit voltage are limited, so that the conversion efficiency reaches a ceiling.

For that reason, there has been proposed a method for improving the conversion efficiency by reducing the surface concentration of the diffusion layer in the light-receiving surface while utilizing the method in which the aforementioned thermal diffusion method and screen printing method are combined. For example, an invention in connection with this method is known in U.S. Patent No. 6,180,869. According to this document, even when the surface concentration of the diffusion layer is about 1.0x10²⁰ cm⁻² or less, it is possible to form a low ohmic contact. The reason is that a compound including a dopant is added around a silver filler included in an electrode paste. As a result of this, the dopant forms a high-concentration layer directly beneath the electrode upon firing the electrode.

However, with the method for adding the compound including the dopant around the silver filler included in the electrode paste as described above, since the contact cannot be formed stably, there are problems that a fill factor is low and reliability is also low.

Additionally, as a method for improving the conversion efficiency by forming a high-concentration diffusion layer (emitter layer) that includes a dopant in high concentration only directly beneath the electrode to thereby reduce the surface concentration of the diffusion layer in other area of the light-receiving surface, namely by forming a two-stage emitter, for example, "photoelectric conversion device and manufacturing method for the same" is known in Japanese Patent Application Laid-open (Kokai) No. 2004-273826. This method changes an electrode formation method for a solar cell with an embedded type electrode, which is known in Japanese Patent Application Laid-open (Kokai) No. 8-37318 and Japanese Patent Application Laid-open (Kokai) No. 8-191152, from an electrolytic plating method to a screen printing method. It is described that this makes manufacturing control easy and achieves a reduction in manufacturing cost, either.

With the method for manufacturing the solar cell with the embedded type electrode like this, however, it is necessary to perform the diffusion process at least twice, so that it is complicated and it leads to an increase in cost.

Meanwhile, as another method for improving the conversion efficiency by forming the two-stage emitter, for example, "method for manufacturing solar cell" (Japanese Patent Application Laid-open (Kokai) No. 2004-221149) is known. It is proposed in this document that different coatings of a plurality of types of coating materials are simultaneously performed by an inkjet method and areas that differ in dopant concentration and dopant type are formed by a simple process.

In fabrication of the solar cell, using the dopant coating by the inkjet method like this, however, when a phosphoric acid or the like is used as the dopant, measures against corrosion is required, so that an apparatus therefor will be complicated and maintenance thereof will be complicated, either. Meanwhile, even when the coating materials that differ in dopant concentration and dopant type are differently coated by the ink jet method, a desired concentration difference is no longer obtained due to autodoping when they are diffused in one heat treatment.

Moreover, as another method for improving the conversion efficiency by forming a high-concentration diffusion layer only directly beneath the electrode to thereby reduce the surface concentration of the diffusion layer in other area of the light-receiving surface, for example, "method for manufacturing solar cell" (Japanese Patent Application Laid-open (Kokai) No. 2004-281569) is known.

With this method, however, it is necessary to perform heat treatment twice according to the specification of Japanese Patent Application Laid-open (Kokai) No. 2004-281569, leading to complicated process. When the heat treatment is reduced to one time because the process is complicated, a dopant concentration in portions other than a portion directly beneath the electrode of the light-receiving surface is also increased due to autodoping, it stops indicating high conversion efficiency.

JP 2004 221149 A discloses a method of inexpensively manufacturing a solar cell with higher photoelectric conversion efficiency capable of raising the dopant concentration only for a portion in contact with an electrode without using many processes as in photolithography when an application agent is coated and a dopant is diffused at a high temperature. The manufacturing method of the solar cell is adapted such that in the solar cell including a pn junction is formed with the aid of an application/diffusion method using a singly crystal silicon substrate or a polycrystalline silicon substrate as a substrate, wherein the application agents are independently applied on the substrate by making use of an ink jet method taking the application agent as an ink.

WO 00/54341 A1 discloses a doping paste for the selective printing onto silicon wafers, e.g. by screen printing.

US 6,777,729 B1 discloses a semiconductor photodiode comprising a semiconductor substrate in which a p-n junction is formed and incident gradiation energy can generate charge carriers separable by an electric field generated by said p-n junction and said carriers are conductible by first and second electrically conductive contacts.

US 6,552,414 B1 discloses a semiconductor device comprising a semiconducting substrate in the shape of a slice, a first and a second doped region in one major surface of the semiconductor substrate, the first doping region having a higher surface dopant concentration than the second doped region; and a metal contact pattern substantially in alignment with said first doped region, wherein the surface dopant concentration of said second doped region increases with distance from within said second doped region towards said first doped region the increasing gradient in the surface concentration of the dopant facilitating carrier transport towards the metal contact pattern substantially along the length of the second doped region.

US 4,152,824 A discloses a method of making a photovoltaic semiconductor solar cell comprising the steps of (1) providing a semiconductor body of a first conductivity type and having first and second opposite surfaces; (2) forming on said first surface a continuous layer of a material containing a dopant capable upon diffusion into said body of forming a region of a second opposite conductivity type in said body; (3) removing said layer from selected portions of said surface so as to form a grid-like pattern of apertures defined by intervening non-removed sections of said layer; (4) heating said body in an atmosphere containing said dopant at a temperature at which said dopant will diffuse into said body from said layer and said atmosphere so as to form in said body relatively deep diffused regions or opposite conductivity type in line with said apertures and relatively shallow diffused regions of said opposite conductivity type in line with said intervening layer sections, said regions establishing a junction within said body; and (5) forming conductive contacts on said surfaces with the contacts of said first surface confirming to and overlying said deep diffused regions.

WO 96/28851 A1 discloses a method for producing a solar cell comprising the steps of applying a boron dopant, treating the wafer in an oxygen-containing atmosphere, removing a diffusion swelling layer and an oxide layer, introducing phosphor and applying an aluminum-containing back contact.

The present invention provides a method for manufacturing a solar cell according to claim 1.

As described above, after coating the first coating material containing a dopant and an agent for preventing a dopant from scattering, and the second coating material containing a dopant, are coated on the semiconductor substrate having the first conductivity type so that the second coating material may contact with at least the first coating material, the first diffusion layer and the second diffusion layer the second diffusion layer having a conductivity is lower than that of the first diffusion layer are simultaneously formed by diffusion heat treatment. As a result of this, formation of a two-stage emitter composed of a high-concentration diffusion layer and a low-concentration diffusion layer, which has been complicated, for example, in diffusion mask formation or the like, so far will be extremely simple, resulting in a reduction in manufacturing cost. Additionally, since a sufficient surface concentration is maintained in the first diffusion layer that will be the high-concentration layer area, low ohmic contact can be formed readily. And, since out-diffusion of the dopant from the first coating material is prevented by the agent for preventing a dopant from scattering, a surface concentration difference between the high-concentration diffusion layer and the low-concentration diffusion layer having the two-stage emitter is certainly formed. Therefore, a highly efficient solar cell can be manufactured maintaining the production yield on a high level.

In this case, preferably, the second coating material includes an agent for preventing autodoping.

As described above, if the second coating material includes an agent for preventing autodoping, the autodoping to the second diffusion layer is further prevented in cooperation with the agent for preventing a dopant from scattering of the first coating material. And thus, the surface concentration difference between the high-concentration diffusion layer and the low-concentration diffusion layer of the two-stage emitter is certainly formed.

Moreover, a comparative example not forming part of the present invention provides a method for manufacturing a solar cell by forming a p-n junction in a semiconductor substrate having a first conductivity type, wherein, at least: a groove is formed on the semiconductor substrate of the first conductivity type; a first coating material containing a dopant and an agent for preventing a dopant from scattering is coated on the whole surface of the substrate; and, a first diffusion layer formed in a bottom of the groove on the semiconductor substrate, and a second diffusion layer formed in a portion other than the bottom of the groove the second diffusion layer having a conductivity is lower than that of the first diffusion layer are simultaneously formed by diffusion heat treatment.

As described above, after the groove is formed on the semiconductor substrate having the first conductivity type, the first coating material containing a dopant and an agent for preventing a dopant from scattering is coated on the whole surface of the substrate; and then, the first diffusion layer formed in the bottom of the groove on the semiconductor substrate, and the second diffusion layer formed in the portion other than the bottom of the groove the second diffusion layer having a conductivity is lower than that of the first diffusion layer are simultaneously formed by diffusion heat treatment. As a result of this, formation of the two-stage emitter composed of a high-concentration diffusion layer and a low-concentration diffusion layer by one coating of the coating material will be extremely simple, resulting in a reduction in manufacturing cost. Moreover, since a sufficient surface concentration is maintained in the first diffusion layer which is formed in the bottom of the groove and is the high-concentration layer area, low ohmic contact can be formed readily. And, since the out-diffusion and the autodoping of the dopant are prevented by the agent for preventing a dopant from scattering, a surface concentration difference between the high-concentration diffusion layer and the low-concentration diffusion layer having the two-stage emitter is certainly formed. Therefore, a highly efficient solar cell can be manufactured maintaining the production yield on a high level.

In this case, preferably, the diffusion heat treatment is performed under an atmosphere of a vapor-phase diffusion source.

As described above, if the diffusion heat treatment is performed under the atmosphere of the vapor-phase diffusion source, a dopant concentration distribution within the surface in the low-concentration diffusion layer will be uniform, thereby making it possible to manufacture the solar cell without a variation in performance.

In addition, the agent for preventing a dopant from scattering or the agent for preventing autodoping includes a silicon compound.

As described above, if the agent for preventing a dopant from scattering or the agent for preventing autodoping includes a silicon compound, the out-diffusion and the autodoping of the dopant can be effectively prevented. Therefore, a surface concentration difference between the high-concentration diffusion layer and low-concentration diffusion layer in the two-stage emitter can be formed extremely certainly. Moreover, if it is the silicon compound, it does not become impurity, either.

Additionally, the first coating material and the second coating material are differed from each other in any one of at least, the percentage of a dopant content, a viscosity, contents of the agent for preventing a dopant from scattering and the agent for preventing autodoping, and a dopant type; and/or, coating film thicknesses of the first coating material and the second coating material during coating are differed from each other.

As described above, the first coating material and the second coating material are differed from each other in any one of at least, the percentage of a dopant content, a viscosity, contents of the agent for preventing a dopant from scattering and the agent for preventing autodoping, and a dopant type, or coating film thicknesses of the first coating material and the second coating material during coating are differed from each other, or these are combined with other, thereby, making it possible to extremely certainly form the surface concentration difference between the high-concentration diffusion layer and low-concentration diffusion layer in the two-stage emitter.

Moreover, preferably, the percentage of the dopant content of the first coating material is higher than the percentage of the dopant content of the second coating material by 4 times or more.

As described above, if the percentage of the dopant content of the first coating material is higher than the percentage of the dopant content of the second coating material by 4 times or more, it is possible to certainly form the surface concentration difference between the high-concentration diffusion layer and low-concentration diffusion layer in the two-stage emitter.

Moreover, preferably, the silicon compound included in the agent for preventing a dopant from scattering is SiO₂, and the silicon compound included in the agent for preventing autodoping is a precursor of a silicon oxide.

As described above, if the silicon compound included in the agent for preventing a dopant from scattering is SiO₂, particularly is a silica gel, and the silicon compound included in the agent for preventing autodoping is the precursor of the silicon oxide, while the dopant viscosity of the coating material can be effectively controlled according to respective applications, the out-diffusion and the autodoping of the dopant can be prevented, thereby, making it possible to extremely certainly form the surface concentration difference between the high-concentration diffusion layer and low-concentration diffusion layer in the two-stage emitter.

Moreover, preferably, a third coating material containing a silicon compound is coated so as to cover an upper portion of the first coating material and/or the second coating material, and the diffusion heat treatment is performed thereafter.

As described above, if the third coating material containing a silicon compound is coated so as to cover the upper portion of the first coating material and/or the second coating material, and the diffusion heat treatment is performed thereafter, the out-diffusion and the autodoping can be further prevented, thereby making it possible to extremely certainly form a surface concentration difference between the high-concentration diffusion layer and the low-concentration diffusion layer having the two-stage emitter by one heat treatment.

Moreover, preferably, a surface of the diffusion layer formed by the diffusion heat treatment is etched back.

As described above, if the surface of the diffusion layer formed by the diffusion heat treatment is etched back, an area where a surface level of the low-concentration diffusion layer is particularly much is removed, and thus making it possible to improve the performance of the solar cell.

Moreover, preferably, the surface of the diffusion layer formed by the diffusion heat treatment is oxidized.

As described above, even when the surface of the diffusion layer formed by the diffusion heat treatment is oxidized, the area where the surface levels is high is removed during a latter glass etching process, and thus making it possible to improve the performance of the solar cell.

Moreover, the first diffusion layer and the second diffusion layer can be formed in at least either side of a light-receiving surface and a backside of the light-receiving surface of the semiconductor substrate.

As described above, the first diffusion layer and the second diffusion layer are formed in at least either side of the light-receiving surface and the backside of the light-receiving surface of the semiconductor substrate, so that the solar cell with the conventional structure can be readily manufactured, and in addition to that, it is possible to readily form a BSF layer in the whole backside or a part of it, and to readily manufacture a backside contact type solar cell in which positive/negative electrodes which have been formed through complicated processes so far are put together on one side.

Moreover, a solar cell manufactured by any one of the aforementioned manufacturing methods is presented as an example useful for understanding the present invention, wherein, the first diffusion layer having a conductivity type opposite to the first conductivity type that the semiconductor substrate has, and the second diffusion layer, a conductivity of the second diffusion layer is lower than that of the first diffusion layer having the opposite conductivity type, are formed in the light-receiving surface of the semiconductor substrate.

As described above, if it is a product in which the first diffusion layer having the conductivity type opposite to the first conductivity type that the semiconductor substrate has, and the second diffusion layer, a conductivity of the second diffusion layer is lower than that of the first diffusion layer having the opposite conductivity type are formed in the light-receiving surface of the semiconductor substrate, it will be a high-performance solar cell having the two-stage emitter with a structure similar to that of the conventional one, at low cost and with high manufacturing yield.

In this case, preferably, at least a diffusion layer having the same conductivity type as that of the first conductivity type is further formed in the backside of the light-receiving surface.

As described above, if it is a product in which at least the diffusion layer having the same conductivity type as that of the first conductivity type is further formed in the backside of the light-receiving surface, it will be a solar cell in which the BSF layer is formed in the whole backside or a part of it.

Moreover, a solar cell manufactured by any one of the aforementioned manufacturing is presented as an example useful for understanding the invention, wherein: the first diffusion layer having a conductivity type opposite to the first conductivity type that the semiconductor substrate has; the second diffusion layer having the opposite conductivity type; a conductivity of the second diffusion layer is lower than that of the first diffusion layer having the opposite conductivity type; and, the first diffusion layer, the second diffusion layer, and a diffusion layer having the same conductivity type as that of the first conductivity type are formed in the backside of the light-receiving surface of the semiconductor substrate.

As described above, if it is a product in which the first diffusion layer having the conductivity type opposite to the first conductivity type that the semiconductor substrate has, the second diffusion layer having the opposite conductivity type the second diffusion layer having a conductivity is lower than that of the first diffusion layer having the opposite conductivity type, and the diffusion layer having the same conductivity type as that of the first conductivity type, are formed in the backside of the light-receiving surface of the semiconductor substrate, it will be a high-performance backside contact type solar cell at low cost and with high manufacturing yield.

Moreover, a method for manufacturing a semiconductor device, is presented as an example useful for understanding the invention, wherein, at least: a first coating material containing a dopant and an agent for preventing a dopant from scattering, and a second coating material containing a dopant, are coated on a semiconductor substrate having a first conductivity type; and, a first diffusion layer formed by coating the first coating material, and a second diffusion layer formed by coating the second coating material, the second diffusion layer having a conductivity is different from that of the first diffusion layer are simultaneously formed by a diffusion heat treatment.

As described above, if after coating the first coating material containing the dopant and the agent for preventing a dopant from scattering, and the second coating material containing the dopant, are coated on the semiconductor substrate having the first conductivity type, the first diffusion layer formed by coating the first coating material, and the second diffusion layer formed by coating the second coating material the second diffusion layer having a conductivity is different from that of the first diffusion layer are simultaneously formed by diffusion heat treatment, the out-diffusion of the dopant can be prevented. Therefore, the semiconductor device having the diffusion layers that differ in surface concentration of the dopant can be manufactured within the surface at low cost and with high manufacturing yield.

Moreover, an example of a coating material useful for understanding the present invention is presented, which is coated on a semiconductor substrate to dope a dopant into the semiconductor substrate by thermal diffusion, wherein the coating material includes at least a dopant and an agent for preventing a dopant from scattering.

As described above, if it is the coating material including at least a dopant and an agent for preventing a dopant from scattering, it will be a coating material which can prevent the out-diffusion of the dopant when this is coated on the semiconductor substrate to perform the thermal diffusion of the dopant.

In this case, preferably, the agent for preventing a dopant from scattering includes a silicon compound.

As described above, if the agent for preventing a dopant from scattering includes a silicon compound, the out-diffusion of the dopant can be effectively prevented, and it will be a coating material, which is not an impurity to the silicon wafer.

Moreover, preferably, the silicon compound is SiO₂.

As described above, if the silicon compound is SiO₂, particularly is a silica gel, while the dopant viscosity of the coating material is effectively controlled, it will be a coating material which can effectively prevent the out-diffusion of the dopant.

Moreover, preferably, the coating material further includes a thickener.

As described above, if the coating material further includes a thickener, it will be a coating material in which the viscosity is effectively controlled. As this thickener, for example, polyvinyl alcohol, polyvinyl pyrrolidone, polyvinyl methyl ether, polyvinyl butyral, polyvinyl acetate and copolymers of these, cellulose derivative, or acrylic resin is preferable.

Moreover, the coating material is a coating material for screen printing.

As described above, if the coating material is the coating material for screen printing, it can be readily coated by a screen printer, so that it will be a coating material, which can readily perform thermal diffusion of the dopant.

According to the method for manufacturing the solar cell of the present invention, formation of the two-stage emitter composed of the high-concentration diffusion layer and the low-concentration diffusion layer, which has been complicated, for example in diffusion mask formation or the like so far will be extremely simple, resulting in a reduction in manufacturing cost. Meanwhile, since a sufficient surface concentration is maintained in the first diffusion layer that will be the high-concentration layer area, a low ohmic contact can be formed readily. And, the out-diffusion of the dopant is prevented by the agent for preventing a dopant from scattering. Therefore, a surface concentration difference between the high-concentration diffusion layer and the low-concentration diffusion layer having the two-stage emitter is certainly formed. Therefore, the high-performance solar cell can be manufactured while maintaining a manufacturing yield at high level.

Moreover, the solar cell will be a backside contact type solar cell or a high performance solar cell having the two-stage emitter, at low cost and with high manufacturing yield.

Further, according to the method for manufacturing the semiconductor device, a semiconductor device having diffusion layers that differ in surface concentration of the dopant within the surface can be manufactured at low cost and with high manufacturing yield.

Still further, if it is the coating material of the present invention, it will be a coating material, which can prevent the out-diffusion of the dopant when this is coated on the semiconductor substrate to perform thermal diffusion of the dopant.

### BRIEF DESCRIPTION OF THE DRAWINGS

Fig. 1 illustrates a cross-sectional structure of an example of a solar cell useful for understanding the invention;
Fig. 2(a) is a flow chart illustrating an example of an embodiment of a method for manufacturing the solar cell according to the present invention, and Fig. 2(b) is a flow chart illustrating an example of a conventional method for manufacturing the solar cell which forms a two-stage emitter using a mask;
Fig. 3 illustrates an explanatory diagram for explaining the method for manufacturing the solar cell shown in Fig. 2(a);
Fig. 4 is a diagram illustrating an antireflection structure (random texture) of a single crystal solar cell;
Fig. 5 illustrates an explanatory diagram for explaining another embodiment of the method for manufacturing the solar cell according to the present invention;
Fig. 6 illustrates an explanatory diagram for explaining a diffusion layer forming method during a diffusion heat treatment process in accordance with still another embodiment of the method for manufacturing the solar cell according to the present invention;
Fig. 7 illustrates a cross-sectional structure of a backside contact type solar cell, which is another example of the solar cell of the present invention;
Fig. 8(a) is a diagram illustrating a situation of an electrode and a connection seen from a backside of the backside contact type solar cell module, Fig. 8(b) is a diagram illustrating a situation of a connection seen from a side of the backside contact type solar cell module, and Fig. 8(c) is a diagram illustrating a situation of a connection seen from a side of a common solar cell module;
Fig. 9 illustrates a cross-sectional structure of still another example of the solar cell useful for understanding the invention;
Fig. 10 is a diagram illustrating an external quantum efficiencies in Example 1 and Example 3; and
Fig. 11 illustrates an explanatory diagram for explaining another example of a method useful for understanding the method for manufacturing the solar cell according to the present invention.

### BEST MODE(S) FOR CARRYING OUT THE INVENTION

Hereinafter, embodiments of the present invention will be described concretely, but the present invention is not limited to these.

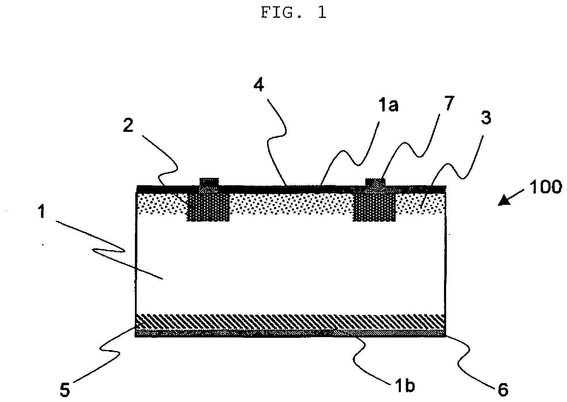

Fig. 1 illustrates a cross-sectional structure of an example of a solar cell useful for understanding the invention.

This is a solar cell 100 in which a high-concentration emitter layer 2 which is a first diffusion layer having a conductivity type opposite to the first conductivity type that a semiconductor substrate 1 has, and a low-concentration emitter layer 3 which is a second diffusion layer, the second diffusion layer having a conductivity is lower than that of the high-concentration emitter layer 2 are formed in a light-receiving surface 1a of the semiconductor substrate. And, a BSF layer 5, which is a diffusion layer and has at least the same conductivity type as the first conductivity type, is preferably formed in a backside 1b of the light-receiving surface.

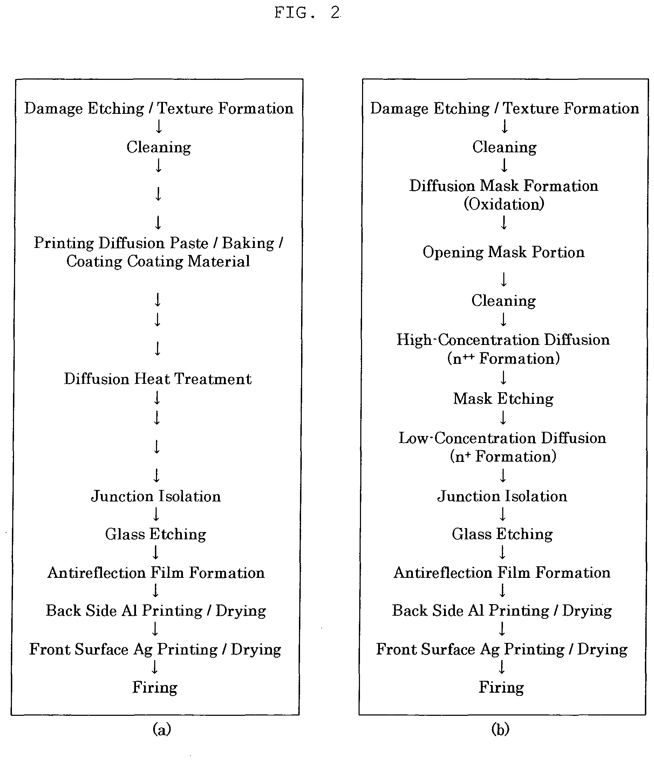

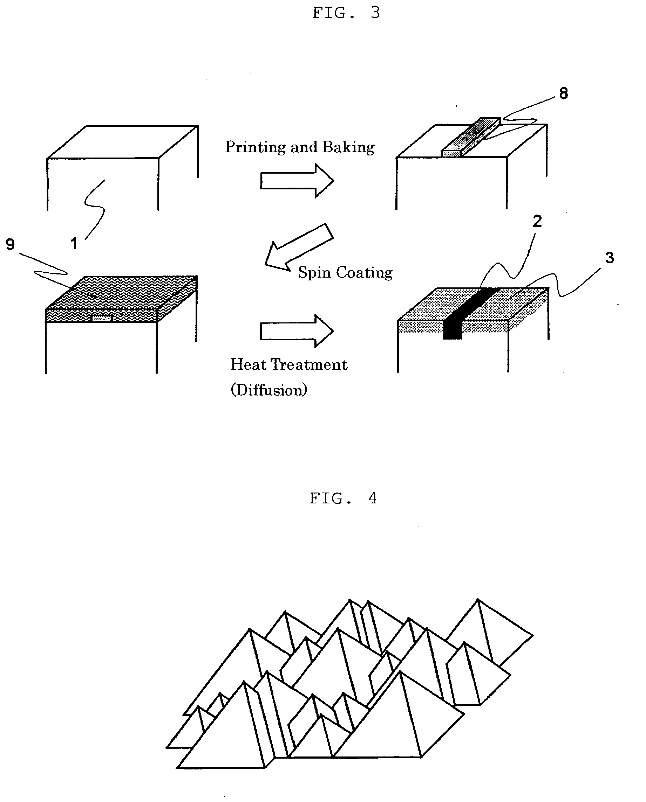

Hereinafter, a manufacturing flow of the solar cell shown in Fig. 1 will be explained. Fig. 2(a) is a flow chart illustrating an example of an embodiment of a method for manufacturing the solar cell according to the present invention, and Fig. 2(b) is a flow chart illustrating an example of a conventional method for manufacturing the solar cell which forms a two-stage emitter using a mask. Further, Fig. 3 illustrates an explanatory diagram for explaining the method for manufacturing the solar cell shown in Fig. 2(a).

First, the semiconductor substrate 1 of the first conductivity type is prepared. Although characteristics of the semiconductor substrate 1 are not limited in particular, there may be used a single crystal silicon substrate having such characteristics that, for example, the crystal plane orientation is (100), the size is 15 cm square and 250 micrometer thickness, the resistivity as sliced is 2 ohm-cm (dopant concentration is 7.2x10¹⁵ cm⁻³), gallium is doped, and the first conductivity type is a p-type. This is dipped in, for example, 40 weight percent aqueous sodium hydroxide solution, and a damage layer thereof is removed by etching. The substrate 1 may be fabricated by either of the methods of the CZ method and the float zone (FZ) method. The substrate resistivity is preferably 0.1 to 20 ohm-cm. And, that the substrate resistivity is 0.5 to 2.0 ohm-cm is suitable for manufacturing the solar cell with high performance, in particular. Additionally, although the aqueous sodium hydroxide solution is used for removing the damages of the substrate 1 in the above description, a strong alkaline solution, such as potassium hydroxide, may be used. Moreover, acid solutions, such as hydrofluoric nitric acid, may also achieve the similar object.

Normally, for the solar cell, it is preferable to form a uneven shape in the surface thereof. The reason is that in order to reduce a reflectance of a visible light region, the light must be reflected at the light-receiving surface at least two times or more. For that reason, the substrate having subjected to the damage etching is dipped in a solution in which an isopropyl alcohol is added to, for example, a 3 weight percent sodium hydroxide, and is subjected to wet etching, so that the random textures as shown Fig. 4 are formed in both sides. The size of each of these hills is about 1 to 20 micrometers. Other exemplary surface uneven structures include a V-groove and a U-groove. These can be formed utilizing a grinding machine. Meanwhile, in order to form a random uneven structure, acid etching, reactive ion etching, or the like may be used as an alternative method. Incidentally, since the texture structures formed in both sides (light-receiving surface 1a, backside 1b) of the substrate in Fig. 1 are fine, description thereof is omitted in the drawing.

Subsequently, after cleaning the substrate, a diffusion paste 8 containing a dopant, such as a phosphoric acid or the like, and an anti-scattering agent for this dopant is printed and coated, as a first coating material, on the light-receiving surface 1a of the substrate by a screen printing apparatus. If the diffusion paste 8 is for screen printing at this time, it can be readily coated by the screen printing apparatus. In addition, if it is a diffusion paste containing a dopant and an agent for preventing a dopant from scattering like this, out-diffusion of the dopant can be prevented when this is coated on the semiconductor substrate and is performed thermal diffusion of the dopant. Printing at this time can be formed into a line pattern of stripe shape, or a dot pattern, and the printing pattern in the case of the line pattern can be formed of lines with 2 mm pitch and 150 micrometer width, for example. The agent for preventing a dopant from scattering may include a silicon compound. And, most preferably, when the silicon compound is SiO₂, for example a silica gel, to be mixed therein, viscosity of the diffusion paste can be effectively controlled for forming the high-concentration diffusion layer. Namely, since the viscosity is high, the dopant can be kept at high concentration, thereby making it possible certainly prevent the out-diffusion.

Subsequently, the substrate on which the diffusion paste 8 is printed is baked at 700 degrees C, for 30 minutes, and thereafter a coating material 9 containing a dopant, such as a phosphorus pentoxide or the like as a second coating material, and a silicon compound preferably including a precursor of a silicon compound, such as an alkoxysilane or the like as an agent for preventing autodoping is coated on the same surface so as to contact with the diffusion paste 8. Although such coating can be implemented by spin coating under conditions of, for example 3000 rpm and 15 seconds, the coating may be performed by screen printing. Thereafter, the sample substrate fabricated as described above is put into a heat treatment furnace to be subjected to diffusion heat treatment while being kept at 880 degrees C, for 30 minutes, and is then taken out. As a result of this, a first diffusion layer 2 (it is also called a high-concentration diffusion layer or a high-concentration emitter layer), and a second diffusion layer 3 (it is also called a low-concentration diffusion layer or a low-concentration emitter layer), the second diffusion layer having a conductivity is lower than that of the first diffusion layer can be simultaneously formed, resulting in a formation of a p-n junction. A sheet resistance of a portion other than a diffusion paste printing portion, which is the low-concentration emitter layer, namely, a portion where only the coating material 9 is coated can be set to 80 to 110 ohms per square. Meanwhile, a surface concentration of the dopant of the portion where the diffusion paste 8 is printed can be set to about 2x10²⁰ cm⁻².

In the above description, since the first coating material is a high viscosity paste coated by the screen printing, it can contain a high-concentration dopant and the coating thickness can be thickened, thus allowing a formation of the high-concentration diffusion layer. In addition, since the agent for preventing a dopant from scattering is mixed at this time, the viscosity thereof is further increased, and the out-diffusion can also be prevented. Meanwhile, the second coating material is a low viscosity material, which is coated by spin coating, resulting in a thin coating thickness. Hence, the low-concentration diffusion layer can be formed. If the agent for preventing autodoping is mixed therewith at this time, a film will be formed on the surface and the autodoping will be prevented.

Next, junction isolation is performed using a plasma etcher. In this process, a plurality of sample substrates are stacked so as for a plasma and a radical not to enter into the light-receiving surface 1a and the backside 1b, and a substrate end surface thereof is removed by several micrometers as they are.

Subsequently, after etching a phosphorus glass formed on the surface by a fluoric acid, a nitride film is deposited as a surface protection film (passivation film) and an antireflection film 4 on the emitter layer using a direct plasma CVD apparatus with a frequency of 13.56 MHz. Since this passivation film and antireflection film 4 serves also as the antireflection film, a film thickness of 70 to 100 nm is suitable. There are an oxide film, a titanium dioxide film, a zinc oxide film, a tin oxide film, and the like as other antireflection films, and they can be alternative. Moreover, while the forming method also includes a remote plasma CVD method, a coating method, a vacuum deposition method, or the like in addition to the above method, it is suitable to form the nitride film by the plasma CVD method as mentioned above from an economical viewpoint. Further, if a film whose refractive index is 1 to 2, for example, magnesium fluoride film, which reduces a total reflectance to the smallest, is formed on the aforementioned antireflection film, the reflectance is further reduced, thereby increasing a generation current density.

Next, a paste composed of, for example aluminum, is coated on the backside 1b using a screen printing apparatus or the like, and is then dried. Further, an Ag electrode with, for example a width of 80 micrometer is printed also on the light-receiving surface 1a side with use of a comb-type electrode pattern printing plate using a screen printing apparatus or the like, and is then dried. In this case, it is printed by utilizing an alignment mechanism so that the comb-type electrode may be placed on a portion where the diffusion paste is printed in a stripe shape. The alignment method includes a method for directly determining the electrode position from a color of the high-concentration diffusion layer, or a method in which the substrate is marked in advance and the diffusion paste and the electrode are printed using the mark.

Thereafter, firing is performed according to a predetermined heat profile to form a backside electrode 6 and a front surface comb-type electrode 7. These electrodes can be formed by a vacuum deposition method, a sputtering method, or the like not based only on the aforementioned printing method. Thus, the solar cell shown in Fig. 1 is manufactured.

Meanwhile, the manufacturing flow of another conventional solar cell for forming the two-stage emitter using a mask will be described using Fig. 2(b).

First, a semiconductor substrate, such as a p-type single crystal silicon substrate or the like, for example, 15 cm square, as slice, and gallium-doped, is prepared in a manner similar to the first embodiment of the present invention, and damage etching and random texture formation are performed.

After cleaning the substrate, an oxide film to be a diffusion mask is formed on the surface by oxidation. As a diffusion mask, at least 100 nm in thickness is required for this oxide film.

Subsequently, in order to form a high-concentration diffusion layer in line form at 2 mm pitch, it is necessary to open the diffusion mask in line form. As the method, there is a method for covering a portion not to be opened by resist printing, and etching a portion to be opened using a fluoric acid. In the present example, the opening is performed by chipping off the oxide film in line form utilizing a dicing saw. In this case, although the semiconductor substrate is partially chipped off with the oxide film, it does not affect characteristics since the opening is near the contact.

After the partial opening of the mask, cleaning is performed, and POCl₃ vapor-phase diffusion is performed so that a sheet resistance of the diffusion portion may be, for example, 40 ohms per square or less, to thereby form a high-concentration diffusion layer (for example, n⁺⁺ layer). Subsequently, mask etching is performed, and POCl₃ vapor phase diffusion is then performed to the whole light-receiving surface so that the sheet resistance of the diffusion portion may be 100 ohms per square, to thereby form a low-concentration diffusion layer (for example, n+ layer). The two-stage emitter is formed in this way.

A junction isolation process to be the next process and the subsequent processes thereof can be performed in a manner similar to the processes of the aforementioned first example as shown in Fig. 2(a).

The method for manufacturing the solar cell having the two-stage emitter according to the aforementioned conventional example is an extremely orthodox method. However, when comparing Fig. 2(a) and Fig. 2(b), a manufacturing cost of the manufacturing method according to the present invention as shown in Fig. 2(a), which has overwhelmingly few process steps, is greatly lower than that shown in Fig. 2(b), so that it can be said to be superior. Consequently, it is possible to produce competitive products in the solar cell market with the manufacturing method according to the present invention.

Incidentally, although the solar cell which is one of the semiconductor devices has been described in full detail, it is needless to say that the present invention is not limited only to the solar cell, and the present invention is applicable also to other semiconductor devices having diffusion layers that differ in surface concentration within the surface.

Namely, If it is the method for manufacturing the semiconductor device in which after coating the first coating material containing the dopant and the agent for preventing a dopant from scattering, and the second coating material containing the dopant, are coated on the semiconductor substrate having the first conductivity type, the first diffusion layer formed by coating the first coating material, and the second diffusion layer formed by coating the second coating material the second diffusion layer having a conductivity is different from that of the first diffusion layer are simultaneously formed by the diffusion heat treatment, the out-diffusion of the dopant can be prevented. Therefore, the semiconductor device having the diffusion layers that differ in surface concentration of the dopant within the surface can be manufactured with high manufacturing yield and at low cost.

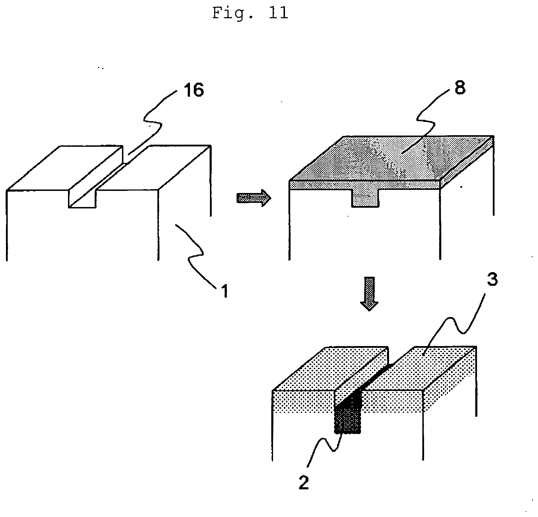

Next, details of the method for forming the high-concentration diffusion layer and the low-concentration diffusion layer according to the manufacturing method for the present invention will be further described. Namely, it is a method in which in order to form the diffusion layers with two concentrations within the same surface by the coating diffusion method, materials that differ in any one of at least the percentage of a dopant content, a viscosity, contents of the agent for preventing a dopant from scattering and the agent for preventing autodoping, a dopant type, or more are used as the first coating material and the second coating material and/or coating film thicknesses of the first coating material and the second coating material are differed from each other during coating. Further, as shown in Fig. 11, there is also a method useful for understanding the invention in which after forming a groove 16 in the semiconductor substrate to coat the first coating material containing the dopant and the agent for preventing a dopant from scattering is coated on the whole surface of the substrate; and, the first diffusion layer formed in the bottom of the groove on the semiconductor substrate, and the second diffusion layer formed in the portion other than the bottom of the groove the second diffusion layer having a conductivity is lower than that of the first diffusion layer are simultaneously formed by the diffusion heat treatment. As described above, the diffusion concentration can be changed by a method for using the coating material that differs in concentration and viscosity, and a method for changing the coating film thicknesses of the coating materials, or forming the groove. Hereinafter, it will be described specifically.

Inventive approaches are required to simultaneously form the high-concentration and low-concentration diffusion layers within the same surface as shown in Fig. 1 by using the coating material containing the same type of dopant and performing one diffusion heat treatment. The reason is that if the dopants having the same diffusion coefficient are simultaneously subjected to the heat treatment at the same temperature, the out-diffusion and the autodoping of the dopants are caused, so that concentration difference between the surface concentrations is not created. Compared with this, the present invention achieves simultaneous formation of the high-concentration and low-concentration diffusion layers by one diffusion heat treatment using the first coating material containing at least the dopant and the agent for preventing a dopant from scattering as mentioned above.

Moreover, in order to achieve the method for the present invention more effectively, there is a method for changing an amount of dopant of each coating material coated on the substrate surface. What is necessary is simply to change the percentage of the dopant content contained in the coating material directly, or just to change the coating film thickness, in order to change the amount of dopant in the coating material. When the percentage of the dopant content is changed, the percentage of the dopant content of the first coating material is higher than the percentage of the dopant content of the second coating material by 4 times or more.

When the coating material with high viscosity is used, it is possible to change the coating film thickness by changing a mesh count of a screen plate. In this case, what is necessary is just to change a content of a methylcellosolve of the coating material, for example, in order to control the viscosity. Meanwhile, the method for forming the groove changes the film thickness structurally.

There is a method for changing the dopant viscosity of the coating material as a method for greatly changing the coating film thickness. And, there is a method for changing an inclusion of the coating material as a method for greatly changing the dopant viscosity of the coating material. For example, adding a thickener to the methylcellosolve as a binder of the coating material preferably increases the viscosity. As this thickener, for example, polyvinyl alcohol, polyvinyl pyrrolidone, polyvinyl methyl ether, polyvinyl butyral, polyvinyl acetate and copolymers of these, cellulose derivative, or acrylic resin is preferable. However, it is not limited to these in particular. In this case, in order to control the dopant viscosity of the coating material and to control the out-diffusion of the dopant, it is particularly preferable to add grains of SiO₂, for example, the silica gel. This will make it possible to increase the coating film thickness, and it will be suitable for the coating material to form the high-concentration diffusion layer. Note herein that, since this binder is unnecessary during the diffusion heat treatment, it is necessary to bake it at 400 degrees C or more and to evaporate it in the atmosphere.

Meanwhile, in order to extremely reduce the viscosity and to control the autodoping of the dopant, it is preferable to mix the dopant in alkoxides, and in order to avoid a lifetime killer from being mixed, it is preferable to mix the dopant in the alkoxides containing silicon which is a precursor of a silicon oxide. As a result of this, it will be suitable for the coating material to form the low-concentration diffusion layer. In this case, when heat at about 150 degrees C is applied, the alkoxide will be hydrolyzed and partially-condensed, so that SiO₂, namely, glass, is generated to serve to prevent the autodoping of the dopant. Since such the coating material cannot be formed thickly and it also spreads easily, it is not suitable for the first coating material.

In addition, the viscosity or the like changes even when a content of the agent for preventing a dopant from scattering and the agent for preventing autodoping, which are for suppressing the out-diffusion of the dopant from the coating material and the autodoping, are changed. As a result of this, it is possible to produce the concentration difference between the diffusion layers within the same surface and under the same heat treatment.

The method for causing the concentration difference using the same type of dopant has been described so far. As other methods, if elements that differ in diffusion coefficient are utilized as the dopant, it is possible to certainly produce the concentration difference even by the heat treatments at the same temperature. For example, the diffusion coefficient of phosphorus at about 900 degrees C is higher than that of antimony by two orders. Both of them are n-type dopants and become a donor to the p-type substrate, and thus it is possible to readily fabricate the two-stage emitter by preparing the coating material whose dopant is phosphorus and the coating material whose dopant is antimony.

Incidentally, when a third coating material containing the silicon compounds, such as a silica gel, is coated so as to cover the upper portion of the first coating material and/or the second coating material, and the aforementioned diffusion heat treatment is performed thereafter, the out-diffusion and the autodoping can be further prevented. Therefore, the surface concentration difference between the high-concentration diffusion layer and low-concentration diffusion layer in the two-stage emitter can be formed extremely certainly.

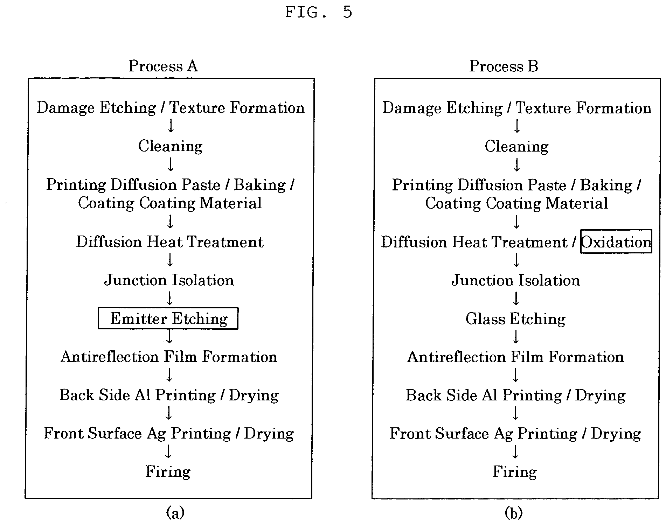

Fig. 5 illustrates an explanatory diagram for explaining another embodiment of the method for manufacturing the solar cell according to the present invention.

In a process A shown in Fig. 5(a), in addition to the diffusion heat treatment in the manufacturing flow shown in Fig. 2(a), a portion where an interface state density of the emitter layer of the surface is considered to be high, namely a portion of about several nanometers in thickness is etched (etched back) while dipping it in a mixed-solution of ammonia and a hydrogen peroxide solution after the diffusion heat treatment. As for an antireflection film formation process and thereafter, the same processes as those shown in Fig. 2(a) are performed thereto, so that the surface level of the low-concentration diffusion layer is particularly reduced. And thus, the performance of the solar cell can be improved.

Note herein that a similar effect will be obtained when the surface is etched not only using a mixed-solution of ammonia and a hydrogen peroxide solution, but also using a hydrofluoric-nitric acid or a weak alkali.

Additionally, in a process B shown in Fig. 5(b), following to the diffusion heat treatment in the manufacturing flow shown in Fig. 2(a), it is kept for 10 minutes within the furnace while only dry oxygen is made to flow without decreasing the temperature. Thereby, an area where the interface state density on the top surface is high is oxidized, and it becomes possible to readily etch it by a glass etching using a diluted fluoric acid after the junction isolation. In this case as well, as for the antireflection film formation process and thereafter, the same processes as those shown in Fig. 2(a) are performed thereto, so that the surface level of the low-concentration diffusion layer is particularly reduced. And thus, the performance of the solar cell can be improved.

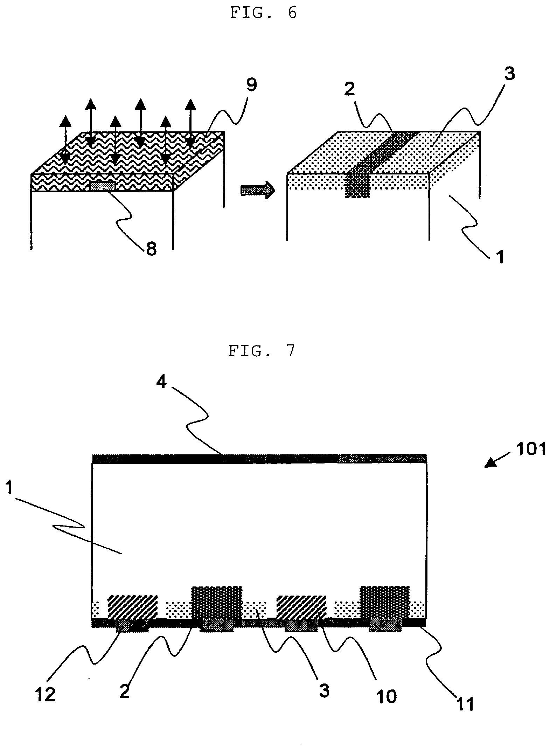

Fig. 6 illustrates an explanatory diagram for explaining a diffusion layer forming method during the diffusion heat treatment process in accordance with still another embodiment of the method for manufacturing the solar cell according to the present invention.

In the embodiment shown in Fig. 6, the diffusion heat treatment is performed under an atmosphere of a vapor-phase diffusion source.

When the diffusion paste is made to contain a silica gel or the like, for example, the out-diffusion of the dopant can be suppressed as described above, but suppression of 100% is actually impossible. As a result of this, since the out-diffused dopant is re-diffused, a concentration distribution of the diffusion layer occurs within the surface. Since this forms an individual difference, namely variations in performance, it is necessary to reduce this as much as possible. Consequently, assuming that the solar cell is fabricated while re-diffusing the dopant to some extent, if the sample is arranged under the atmosphere of the vapor-phase diffusion source where the dopant is fully filled during the diffusion heat treatment, it is possible to make the concentration distribution within the surface of the diffusion layer uniform. By doing this, it is possible to manufacture the solar cell with little variation in performance.

Fig. 7 illustrates a cross-sectional structure of a backside contact type solar cell, useful for understanding the present invention.

The backside contact type solar cell 101 is characterized in that the high-concentration emitter layer 2 which is a first diffusion layer having the conductivity type opposite to the first conductivity type that a semiconductor substrate 1 has, the low-concentration emitter layer 3 which is a second diffusion layer having the opposite conductive type, the second diffusion layer having a conductivity is lower than that of the high-concentration emitter layer 2, and a local BSF layer 10 which is a diffusion layer having the same conductivity type as that of the first conductivity type are formed in the backside of the light-receiving surface of the semiconductor substrate.

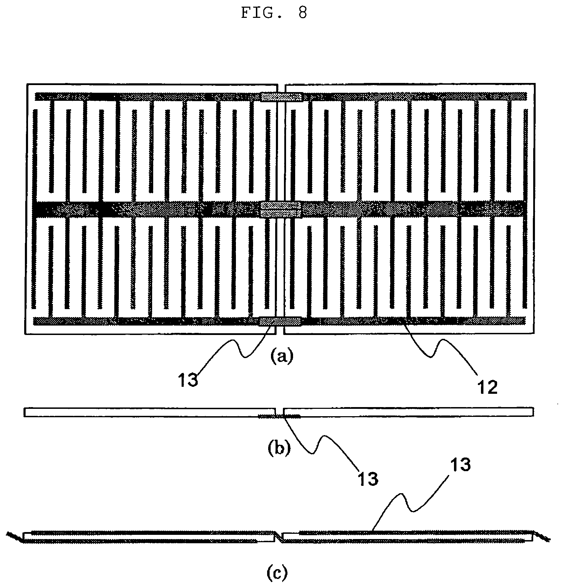

Since the backside contact type solar cell does not have the electrode in the light-receiving surface, there is a feature that appearance is very beautiful. Meanwhile, when the solar cell is modularized, the electrodes which are located next to each other in the light-receiving surface and the backside of the solar cell are typically connected by a tab line 13 with a thickness of 100 to 200 micrometers as shown in Fig. 8(c), and thus there is a disadvantage of causing cracks of the solar cell. In the backside contact type solar cell, however, since what is necessary is to connect them as shown in Figs. 8(a) and 8(b), it also has a feature that the cracks can be extremely reduced.

Although the solar cell structure has many advantages, as described above, the high-concentration diffusion layers with the conductive types opposite to each other, such as the high-concentration p-type diffusion layer and the high-concentration n-type diffusion layer, must be formed in the same surface, thereby causing the process to be extremely complicated.

According to a method described below, however, three types of diffusion layer or more of the same conductivity type as that of the substrate or of the conductivity type opposite to that can be formed in the same surface without any diffusion masks. Since basic process steps are almost the same as those of the conventional fabrication method as well as described above, it can be easily fabricated.

Hereinafter, another example of a method for manufacturing the solar cell will be described.

First, a single crystal silicon substrate in which, for example, the crystal plane orientation is (100), the size is 15 cm square and 200 micrometer thickness, the resistivity as slice is 0.5 ohm-cm, (dopant concentration is 1.01x10¹⁶ cm⁻³), phosphorus is doped, and the conductivity type is n-type is prepared as the semiconductor substrate 1, damage etching is performed by about 30 micrometers in total of both sides using a method similar to that shown in Fig. 2(a), and a texture which is the antireflection structure is further formed on the surface.

Subsequently, after cleaning the substrate, a diffusion paste containing, for example, boron oxide of 15 g/100 ml and the agent for preventing a dopant from scattering as described above (silica gel) is printed by the screen printing apparatus for the purpose of forming the high-concentration emitter layer 2 of a conductivity type opposite to that of the substrate 1. The printing pattern in the case can be formed of lines with 2 mm pitch and 200 micrometer width. Further, a diffusion paste containing, for example, boron oxide of 4 g/100 ml and the agent for preventing autodoping as described above (a precursor of silicon oxide) is printed for the purpose of forming the low-concentration emitter layer 3 of a conductivity type opposite to that of the substrate 1. This printing pattern can be formed of lines with 2 mm pitch and 1600 micrometer width, and it is printed so that a center thereof may overlap with that of the first printing pattern. Further, a diffusion paste containing, for example, a phosphoric acid similar to that used in the description of Fig. 2(a) is printed on an area where the aforementioned boron diffusion paste is not printed for the purpose of forming the local BSF layer 10 of the same conductivity type as that of the substrate 1. This printing pattern can be formed of lines with 2 mm pitch and 200 micrometers width.

After printing, it is baked at 700 degrees C, for 30 minutes, a coating material containing, for example, a silica gel is subsequently spin coated on the same surface under the condition of 3000 rpm and 15 seconds, and this sample substrate is put into a heat treatment furnace as it is to be subjected to diffusion heat treatment. This diffusion heat treatment can be performed on condition of keeping it at 1000 degrees C, for 20 minutes. Next, after performing the junction isolation using the plasma etcher, phosphorus and boron glasses formed on the surface are etched by a fluoric acid like the process shown in Fig. 2(a).

Subsequently, a passivation film and antireflection film 4, such as a nitride film or the like, is deposited 85 nm in thickness on the light-receiving surface using, for example, a direct plasma CVD apparatus. Moreover, a backside passivation film 11, such as a nitride film or the like, is deposited 55 nm in thickness on the backside using the same direct plasma CVD apparatus for the purpose of surface protection. If the thickness of the nitride film on the back is deposited from 70 to 110 nm, it is available as a double-sided light receiving cell.

Next, a comb-type electrode pattern as shown in Fig. 8(a) is printed with an electrode paste composed of Ag in line with the boron and phosphorus high-concentration diffusion layers using a screen printing apparatus with an alignment mechanism.

Subsequently, after drying the electrode paste, it is fired according to a predetermined heat profile to form the backside comb-type electrode 12, and the backside contact type solar cell 101 is accomplished.

The backside contact type solar cell fabricated as described above and that fabricated by the conventional method do not differ in structure, and there is no performance difference therebetween, either. Hence, if the solar cell is fabricated utilizing the present fabrication method, it is possible to enjoy merits that the backside contact type solar cell with very beautiful appearance and extremely few cracks can be simply fabricated without any diffusion masks.

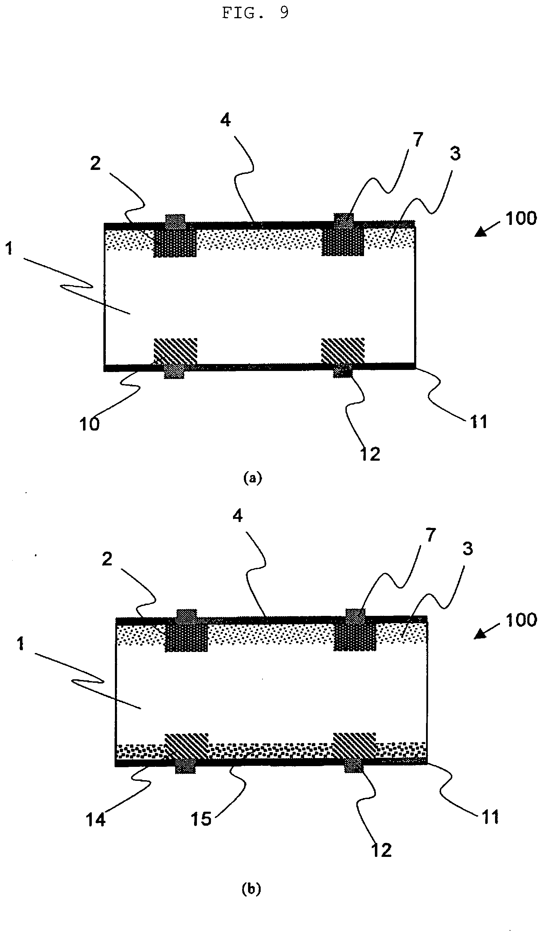

Fig. 9 illustrates a cross-sectional structure of still another example of the embodiment of the solar cell of the present invention. The solar cell based on the general screen printing technology has a structure in which the whole backside surface is covered with the BSF layer 5 by Al, as shown in Fig. 1. It is known that when the area of this BSF layer is reduced and the remaining area on the back is covered with a high quality passivation film, an open circuit voltage will increase, resulting in an increase in output.

The solar cell shown in Fig. 9 is the solar cell in which the area of the BSF layer is reduced like this; an embodiment shown in Fig. 9(a) (hereinafter referred to as sample (A)) is a solar cell in which the local BSF layer 10 of the same conductivity type as that of the substrate 1 is formed in only a near portion directly beneath the contact with the backside comb-type electrode 12; and an embodiment shown in Fig. 9(b) (hereinafter referred to as sample (B)) is a solar cell in which a high-concentration BSF layer 14 of the same conductivity type as that of the substrate 1 is formed in only a near portion directly beneath the contact with the backside comb-type electrode 12, and a low-concentration BSF layer 15 of the same conductivity type as that of the substrate 1 is further formed in all over the backside.

Although the diffusion mask has been required for forming the diffusion layer in a certain portion within the surface according to the conventional fabrication method as described above, the mask is not required according to the manufacturing method for the present invention, allowing a desired structure to be formed simply.

Hereinafter, the embodiment of the method for manufacturing the solar cell in accordance with the present invention when manufacturing the solar cell shown in Fig. 9 will be described.

First, a single crystal silicon substrate in which, for example, the crystal plane orientation is (100), the size is 15 cm square and 250 micrometer thickness, the resistivity as slice is 0.5 ohm-cm (dopant concentration is 3.26x10¹⁶ cm⁻³), gallium is doped, and the conductivity type is p-type is prepared as the semiconductor substrate 1, damage etching is performed by about 30 micrometers in total of both sides using a method similar to that of the process shown in Fig. 2(a), and a texture which is the antireflection structure is further formed on the surface using a method similar to that of the process shown in Fig. 2(a).

Subsequently, after cleaning the substrate, the diffusion paste is printed on an area where the high-concentration diffusion layer is formed on similar conditions described in Fig. 2(a), and the coating material is coated on other areas, for the purpose of forming the two-stage emitter on the light-receiving surface side.

Next, a paste containing a boron oxide which is a dopant of the same conductivity type as that of the substrate 1 and an agent for preventing a dopant from scattering, such as a silica gel, at a ratio of 0.1 g/ml is printed in a line pattern with, for example, 2 mm pitch and 200 micrometer width on the back surface side. Among the samples passed through the processes so far, samples which are baked at 700 degrees C, for 30 minutes as they are, and on the backside of which a coating material 30 containing alkoxysilane is subsequently spin-coated under the condition of 3000 rpm and 15 seconds are defined as sample (A). Meanwhile, among the samples passed through the aforementioned processes, samples, on the whole surface of which a paste containing a boron oxide and an agent for preventing autodoping such as silica or the like is subsequently printed, and which are baked at 700 degrees C, for 30 minutes are defined as sample (B) .

Subsequently, these samples are put into a heat treatment furnace, are kept at 980 degrees C, for 10 minutes and are then taken out.

Next, after performing the junction isolation using the plasma etcher, phosphorus and boron glasses formed on the surface are etched by a fluoric acid like the process shown in Fig. 2(a).

Subsequently, the passivation film and antireflection film 4, such as a nitride film or the like, is deposited, for example, 85 nm in thickness on both sides using a direct plasma CVD apparatus.

Next, a comb-type electrode pattern is printed with an electrode paste composed of Ag in line with the high-concentration diffusion layers on both sides using a screen printing apparatus with an alignment mechanism. After drying the electrode paste, firing is performed according to a predetermined heat profile, and the solar cell as shown in Fig. 9 is fabricated.

In the present embodiment, the BSF area is restricted to only the near portion directly under contact from the whole surface, so that the open circuit voltage is greatly improved as compared with that of the solar cell shown in Fig. 1. Meanwhile, since light absorption near the backside is reduced, a short circuit current is increased. Additionally, since the grid electrode is used on the backside, warpage of the substrate is reduced. This means that thinning will become easy.

Although the low-concentration BSF layer of the sample (B) is formed by adjusting the amount of dopant of the diffusion paste in the aforementioned embodiment, the dopant, which has out-diffused from the diffusion paste for forming the high-concentration BSF layer by reducing the content of a silica gel or the like without putting the dopant, re-diffuses, and thereby also making it possible to form a structure similar to that of the sample (B).

Moreover, if the oxide film with a film thickness of 5 to 30 nm is formed by oxidation before depositing the antireflection film and passivation film, such as a nitride film or the like, the open circuit voltage is further increased, thus resulting in an increase in generating efficiency.

Hereafter, the present invention will be specifically explained with reference to the following examples of the present invention and comparative example. However, the present invention is not limited to these.

### (Example 1 and Comparative Example 1)

As Example 1, a single crystal silicon substrate fabricated by the CZ method according to the process shown in Fig. 2(a), in which the crystal plane orientation was (100), the size was 15 cm square and 250 micrometer thickness, the resistivity as sliced was 2 ohm-cm (dopant concentration was 7.2x10¹⁵ cm⁻³), gallium was doped, and the first conductivity type was a p-type, was prepared. Next, this was dipped in a 40 weight percent aqueous sodium hydroxide solution, and a damage layer thereof was removed by etching. Next, this substrate was dipped in a solution in which an isopropyl alcohol was added to a 3 weight percent sodium hydroxide to be subjected to wet etching, so that a random texture was formed in a surface.

Subsequently, after cleaning the substrate, a diffusion paste containing a phosphoric acid and a silica gel was printed in a light-receiving surface of the substrate by a screen printer. A printing pattern at this time was formed of a line pattern with 2 mm pitch and 150 micrometer width line. The printed substrate was baked at 700 degrees C, for 30 minutes, and a coating material containing a phosphorus pentoxide and an alkoxysilane was subsequently coated on the same surface so as to contact with the diffusion paste. This coating was performed by spin coating under the conditions of 3000 rpm and 15 seconds. Thereafter, the sample substrate fabricated as described above was put into a heat treatment furnace to be subjected to diffusion heat treatment while being kept at 880 degrees C, for 30 minutes, and was then taken out. When a sheet resistance of a portion where only the coating material was coated (portion where the diffusion paste was not printed) was measured, the sheet resistance was from 80 to 110 ohms per square. Meanwhile, when a diffusion profile was verified by a spreading resistance (SR) method, a value of 2x10²⁰ cm⁻² was obtained as a surface concentration of the dopant in a portion where the diffusion paste was printed in a stripe shape.

Next, junction isolation was performed using a plasma etcher. Next, after subsequently etching a phosphorus glass formed on the surface by a fluoric acid, a nitride film with a film thickness of 70 nm was deposited on an emitter layer using a direct plasma CVD apparatus with a frequency of 13.56 MHz.

Next, a paste composed of aluminum was coated on the backside using a screen printing apparatus and so forth, and was then dried. Further, an Ag electrode with a width of 80 micrometer was printed also on the light-receiving surface side with use of a comb-type electrode pattern printing plate using a screen printing apparatus and so forth, and was then dried. In this case, it was printed by utilizing an alignment mechanism so that the comb-type electrode may be placed on a portion where the diffusion paste was printed in a stripe shape. Thereafter, firing was performed according to a predetermined heat profile to form a backside electrode and a front surface comb-type electrode, so that the solar cell was fabricated.

Meanwhile, as Comparative Example 1, a single crystal silicon substrate which was 15 cm square, as-sliced, gallium-doped, and p-type, similar to in Example 1 was prepared, and a solar cell was fabricated according to the process shown in Fig. 2(b).

Current voltage characteristics of the solar cells with 15 cm square, which were fabricated respectively, were measured under a solar simulator (light intensity: 1 kW/m², spectrum: AM1.5 global) in an atmosphere at 25 degrees C. The result will be shown in Table 1.

**[Table 1]**

| | Open circuit voltage (V) | Short circuit current density (mA/cm²) | Conversion efficiency (%) | Fill factor |
|---|---|---|---|---|
| Example 1 | 0.632 | 36.5 | 18.2 | 0.791 |
| Comparative Example 1 | 0.638 | 36.2 | 18.2 | 0.789 |

As shown in Table 1, although the solar cell of Example 1 has few process steps overwhelmingly as compared with the solar cell of Comparative Example 1 according to the conventional fabrication method and has low manufacturing cost, a difference in performance cannot be seen therebetween. Consequently, utilizing the fabrication method in accordance with the present invention makes it possible to produce a competitive product in the solar cell market.

### (Example 2)

As a Example 2, the solar cells were fabricated by various fabrication methods of the two-stage emitter of the present invention. Sheet resistances of the high-concentration layer and the low-concentration layer formed at this time were shown in Table 2. Solar cell characteristics thereof were shown in Table 3 along with them.

In the present example, in order to form the diffusion layers with two concentrations within the same surface by the coating diffusion method, changes in dopant content contained in the coating material, coating film thickness, glass content (silicon compound content), elements, or the like were utilized, as shown in Table 2. In particular, concerning change in coating film thickness, change in viscosity was utilized, or the groove, which is an example not forming part of the invention, was utilized.

Hereinafter, the fabrication method for the two-stage emitter will be described briefly. Incidentally, a series of processes from the texture formation and the diffusion to the electrode formation were similar to those of Example 1.

First, for samples A, C, D, and E, the high-concentration layer and the low-concentration layer were formed by changing items shown in Table 2. For example, in sample A, two types of coating materials in which the dopant content was changed were prepared, and for example, when forming the high-concentration layer, a diffusion paste containing a phosphoric acid of 10g in 100 ml was used. Meanwhile, in sample C, the viscosity was changed by changing a content of a methylcellosolve in the coating material. Contained silicon compounds were a silica gel and an alkoxysilane in sample D, and the content of glass was changed in sample E. Moreover, in the present process, the high-concentration layer had lines with 200 micrometer width and 2.0 mm pitch, and the coating material was printed thereon by screen printing, whereas the low-concentration layer was formed by spin coating with the coating material. Meanwhile, for samples B and F which do not form part of the present invention, screen printing was used for both of the high-concentration layer and the low-concentration layer, and the coating material was coated thereon. Additionally, in sample B, a polyvinyl alcohol was added to the coating material for forming the high-concentration layer, and in sample F, the dopants contained in respective coating materials were set to phosphorus and antimony which differ in diffusion coefficient. At this time, the high-concentration layer had lines with 200 micrometer width and 2.0 mm pitch. Meanwhile, for sample G which does not form part of the present invention, only one type of coating material used in Example 1 was spin coated. One half of these samples A through G were subjected to heat treatment at 880 degrees C, for 30 minutes to thereby complete diffusion. As for the remaining half samples, a coating material including a silica gel was coated on the same surface thereof under the conditions of 3000 rpm and 15 seconds before the heat treatment, and diffusion heat treatment thereto was completed under similar conditions to those described above. Symbol "cover" indicates this film within Table 2. Incidentally, measurement of the sheet resistance was performed with a four point probe method after glass etching. Incidentally, various characteristics of the solar cell shown in Table 3 indicate about this "cover".

**[Table 2]**

| | Change item | Cover | Change details | Sheet resistance (Ω/□) | Cell sample # |
|---|---|---|---|---|---|
| A | Dopant content change High concentration: Phosphoric acid concentration: Phosphorus pentoxide | No (without) | 10g/100ml | 15 | |
| | | | 2.0g/100ml | 80 | |
| | | Yes (with) | 10g/100ml | 15 | A1 |
| | | | 2.0g/100ml | 100 | |
| B | Coating film thickness change | No (without) | 20µm | 25 | |
| | | | 0.2µm | 60 | |
| | | Yes (with) | 20µm | 25 | B1 |
| | | | 0.2µm | 80 | |
| C | Viscosity change | No (without) | 300CP | 25 | |
| | | | 1.1CP | 70 | |
| | | Yes (with) | 300CP | 25 | C1 |
| | | | 1.1CP | 90 | |
| D | Inclusion change | No (without) | Silica gel | 20 | |
| | | | Alkoxysilane | 70 | |
| | | Yes (with) | Silica gel | 20 | D1 |
| | | | Alkoxysilane | 90 | |
| E | Glass content change | No (without) | 10wt% | 20 | |
| | | | 6wt% | 60 | |
| | | Yes (with) | 10wt% | 20 | E1 |
| | | | 6wt% | 80 | |
| F | Element change | No (without) | Phosphorus | 10 | |
| | | | Antimony | 90 | |
| | | Yes (with) | Phosphorus | 10 | F1 |
| | | | Antimony | 110 | |
| G | Groove formation | No (without) | Inside of groove | 40 | |
| | | | outside of groove | 70 | |
| | Coating was only one time | Yes (with) | Inside of groove | 40 | G1 |
| | | | outside of groove | 80 | |

**[Table 3]**

| Sample # | Open circuit voltage (V) | Short circuit current density (mA/cm²) | Conversion efficiency (%) | Fill factor |
|---|---|---|---|---|
| A1 | 0.633 | 36.6 | 18.3 | 0.792 |
| B1,C1,D1 | 0.630 | 36.3 | 18.1 | 0.790 |
| E1 | 0.635 | 36.8 | 18.4 | 0.787 |
| F1 | 0.627 | 36.0 | 17.7 | 0.785 |
| G1 | 0.629 | 36.2 | 17.8 | 0.781 |

As shown in Table 3, although some differences were seen, the solar cell with high conversion efficiency was obtained from all samples in spite of significantly few process steps and a low manufacturing cost, as compared with the common screen printing type solar cell whose conversion efficiency was about 12 to 16%, resulting from effects of the two-stage emitter structure.

### (Example 3)

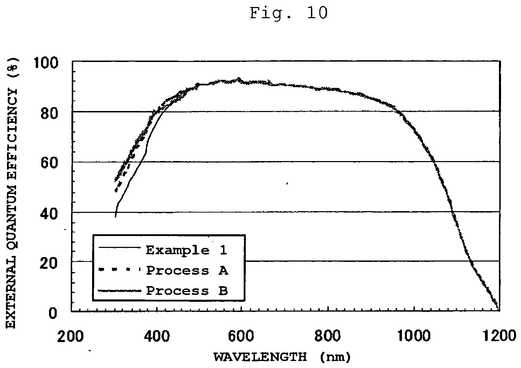

The solar cell was fabricated using the process according to processes A and B shown in Fig. 5. Manufacturing conditions were similar to those of Example 1 other than etch back of the diffusion layer surface, and surface oxidation. In this case, the etch back was performed by dipping the substrate in a mixed-solution of ammonia and a hydrogen peroxide solution after heat treatment to etch the surface by several nanometers. Meanwhile, surface oxidation was performed by making only dry oxygen to flow without decreasing the temperature subsequent to heat treatment to keep the substrate in a heat treatment furnace for 10 minutes. Various characteristics of the solar cell obtained by the present example were shown in Table 4. Incidentally, various characteristics of the solar cell of Example 1 were also shown for comparison. Additionally, spectral sensitivity characteristics (external quantum efficiency) were shown in Fig. 10.

**[Table 4]**

| | Open circuit voltage (V) | Short circuit current density (mA/cm²) | Conversion efficiency (%) | Fill factor |
|---|---|---|---|---|
| Example 3 (process A) | 0.634 | 36.9 | 18.5 | 0.789 |
| Example 3 (process B) | 0.635 | 37.2 | 18.4 | 0.778 |
| Example 1 | 0.632 | 36.5 | 18.2 | 0.791 |

Both the short circuit current and the open circuit voltage of both of the samples subjected to the process A and the process B according to the present example indicates high values as compared with Example 1 in which emitter etch back and surface oxidation were not performed after heat treatment. However, since the surface concentration of the contact portion was also reduced a little, the fill factor was reduced.

The reason why the short circuit current was increased was that quantum efficiency of a short wavelength region was increased after the emitter etch back and the surface oxidation as shown in Fig. 10. The interface state density was reduced by improving the quality of the surface portion of the diffusion layer like the present example, thus making it possible to further improve the performance of the solar cell.

### (Example 4)

Diffusion heat treatment was performed at 900 degrees C under an atmosphere a POCl₃ vapor-phase diffusion source according to the method shown in Fig. 6. As for other conditions, a diffusion paste and a coating material similar to those of Example 1 were used.

Averages and standard deviations that indicate the degree of variation of various characteristics of the solar cell fabricated by the aforementioned method were shown in Table 5.

When the standard deviation within a parenthesis was seen, it turns out that the standard deviation was reduced by the fabrication method for present example, as compared with the case of Example 1. Namely, it can be said that performance variation was improved by the fabrication method for the present example.

**[Table 5]**

| | Open circuit voltage (V) | Short circuit current density (mA/cm²) | Conversion efficiency (%) | Fill factor |
|---|---|---|---|---|
| Example 4 | 0.634 | 36.6 | 18.3 | 0.790 |
| | (0.55) | (0.11) | (0.13) | (0.45) |
| Example 1 | 0.632 | 36.5 | 18.2 | 0.791 |
| | (0.88) | (0.45) | (0.31) | (0.66) |

In table, inside of ( ) (parentheses) indicates standard deviation.

### (Example 5)

The backside contact type solar cell as shown in Fig. 7 was fabricated.

Specifically, a single crystal silicon substrate, in which the crystal plane orientation was (100), the size was 15 cm square and 200 micrometer thickness, the resistivity as sliced was 0.5 ohm-cm (dopant concentration was 1.01x10¹⁶ cm⁻³), phosphorus was doped, and the conductivity type was n-type, was prepared, damage etching was performed by about 30 micrometers in total of both sides using a method similar to that shown in Fig. 2(a), and a texture which was the antireflection structure was further formed on the surface.

Subsequently, after cleaning the substrate, a diffusion paste containing boron oxide of 15 g/100 ml and a silica gel was printed by a screen printing apparatus for the purpose of forming a high-concentration emitter layer. A printing pattern at this time was formed of lines with 2 mm pitch and 200 micrometer width. Further, a diffusion paste containing a boron oxide of 4 g/100 ml and an alkoxysilane was printed for the purpose of forming a low-concentration emitter layer. This printing pattern was formed of lines with 2 mm pitch and 1600 micrometer width, and it was printed so that a center thereof may overlap with that of the first printing pattern. Further, a diffusion paste containing a phosphoric acid similar to that used in the description of Fig. 2(a) was printed on an area where the aforementioned boron diffusion paste was not printed for the purpose of forming a local BSF layer. This printing pattern was formed of lines with 2 mm pitch and 200 micrometer width.

After printing, it was baked at 700 degrees C, for 30 minutes, a coating material containing a silica gel was subsequently spin coated on the same surface under the condition of 3000 rpm and 15 seconds, and this sample substrate was put into a heat treatment furnace as it is. This heat treatment was performed on condition of keeping it at 1000 degrees C, for 20 minutes. Next, after performing junction isolation using a plasma etcher, phosphorus and boron glasses formed on the surface were etched by a fluoric acid like Fig. 2(a).

Subsequently, a nitride film was deposited 85 nm in thickness on the light-receiving surface using a direct plasma CVD apparatus. Meanwhile, a nitride film was deposited 55 nm in thickness on the backside using the same direct plasma CVD apparatus.

Next, a comb-type electrode pattern as shown in Fig. 8(a) was printed with an electrode paste composed of Ag in line with the boron and phosphorus high-concentration diffusion layers using a screen printing apparatus with an alignment mechanism. After drying the electrode paste, it was fired according to a predetermined heat profile to form a backside comb-type electrode, and the backside contact type solar cell was fabricated.

Current voltage characteristics of the fabricated solar cells with 15 cm square were measured under a solar simulator (light intensity: 1 kW/m², spectrum: AM1.5 global) in an atmosphere at 25 degrees C. Various characteristics of the solar cell according to Example 5 and Example 1 were shown in Table 6.

As a result of this, although the short circuit current was reduced, the open circuit voltage and the fill factor were increased as compared with the solar cell having the general structure according to Example 1, the conversion efficiency almost similar to that was obtained also in the backside contact type solar cell according to Example 5.

**[Table 6]**

| | Open circuit voltage (V) | Short circuit current density (mA/cm²) | Conversion efficiency (%) | Fill factor |
|---|---|---|---|---|
| Example 5 | 0.640 | 36.0 | 18.3 | 0.795 |
| Example 1 | 0.632 | 36.5 | 18.2 | 0.791 |

### (Example 6)

The solar cell as shown in Figs. 9(a) and (b) was fabricated.

Specifically, a single crystal silicon substrate in which, for example, the crystal plane orientation was (100), the size was 15 cm square and 250 micrometer thickness, the resistivity as slice was 0.5 ohm-cm (dopant concentration was 3.26x10¹⁶ cm⁻³), gallium was doped, and the conductivity type was p-type was prepared, damage etching was performed by about 30 micrometers in total of both sides using a method similar to that shown in Fig. 2(a), and a texture which was the antireflection structure was further formed on the surface using a method similar to that shown in Fig. 2(a).

Subsequently, after cleaning the substrate, the diffusion paste was printed on an area where the high-concentration diffusion layer was formed under conditions similar to those of Example 1 and Example 2 for the purpose of forming the two-stage emitter on the light-receiving surface side, and the coating material was coated on other areas.

Next, a paste containing a boron oxide and a silica gel at a ratio of 0.1 g/ml was printed on the back surface side in a line pattern of 2 mm pitch and 200 micrometer width. One half of the samples passed through the processes so far were baked at 700 degrees C, for 30 minutes as they are, and a coating material containing alkoxysilane was subsequently spin-coated on the backside under the conditions of 3000 rpm and 15 seconds (sample (A)). Meanwhile, as for the remaining samples, a paste containing a boron oxide and a silica was printed on the whole surface thereof, and baking was performed thereto at 700 degrees C, for 30 minutes (sample (B)).

Subsequently, these samples were put into a heat treatment furnace, were kept at 980 degrees C, for 10 minutes, and were then taken out; junction isolation was then performed using a plasma etcher in a manner similar to that of Fig. 2(a); and thereafter phosphorus and boron glasses formed on the surface were etched by a fluoric acid.

Subsequently, a nitride film was deposited 85 nm in thickness on both sides using a direct plasma CVD apparatus, and then, a comb-type electrode pattern was printed with an electrode paste composed of Ag in line with the high-concentration diffusion layers on both sides using a screen printing apparatus with an alignment mechanism. After drying the electrode paste, firing was performed according to a predetermined heat profile, so that the solar cell as shown in Figs. 9(a) and (b) was fabricated.

Current voltage characteristics of the fabricated solar cells with 15 cm square were measured under a solar simulator (light intensity: 1 kW/m², spectrum: AM1.5 global) in an atmosphere at 25 degrees C. Various characteristics of the solar cell according to Example 6 and Example 1 were shown in Table 7.

**[Table 7]**

| | Open circuit voltage (V) | Short circuit current density (mA/cm²) | Conversion efficiency (%) | Fill factor |
|---|---|---|---|---|
| Example 6 (sample A) | 0.644 | 37.3 | 18.9 | 0.786 |
| Example 6 (sample B) | 0.641 | 37.8 | 19.2 | 0.793 |
| Example 1 | 0.632 | 36.5 | 18.2 | 0.791 |

In the present example, the high-concentration BSF layer was restricted to only a near portion directly under the contact from the whole surface, so that the open circuit voltage was greatly improved as compared with the result of Example 1. Meanwhile, since light absorption near the backside was reduced, the short circuit current was increased. Additionally, since the grid electrode was used on the backside, warpage of the substrate was reduced. This means that thinning will become easy.

## Claims

1. A method for manufacturing a solar cell (100) by forming a p-n junction in a semiconductor substrate (1) having a first conductivity type, wherein, at least: a first coating material (8) containing a dopant of the second conductivity type and an agent for preventing a dopant from scattering, said agent including a silicon compound, is coated on the semiconductor substrate having the first conductivity type by screen printing, and a second coating material (9) containing a dopant of the second conductivity type is coated on the semiconductor substrate having the first conductivity type and the first coating material by spin coating so that the second coating material may be brought into contact with at least the first coating material; and, a first diffusion layer (2) formed by coating the first coating material, and a second diffusion layer (3) formed by coating the second coating material, the second diffusion layer having a conductivity lower than that of the first diffusion layer, are simultaneously formed by a diffusion heat treatment resulting in the formation of said p-n junction, further wherein: the first coating material and the second coating material differ from each other in any one of at least, the percentage of a dopant content, a viscosity, contents of the agent for preventing a dopant from scattering and an agent for preventing autodoping, said agent including a silicon compound, a dopant type and/or, coating film thicknesses of the first coating material and the second coating material during coating; and wherein the percentage of the dopant content of the first coating material is higher than the percentage of the dopant content of the second coating material by 4 times or more.

2. The method for manufacturing a solar cell according to claim 1, wherein the second coating material includes an agent for preventing autodoping, said agent including a silicon compound.

3. The method for manufacturing a solar cell according to claim 1 or 2, wherein the diffusion heat treatment is performed under an atmosphere of a vapor-phase diffusion source.

4. The method for manufacturing a solar cell according to claim 2 or claim 3 when dependent on claim 2, wherein the silicon compound included in the agent for preventing a dopant from scattering is SiO2, and the silicon compound included in the agent for preventing autodoping is a precursor of a silicon oxide.

5. The method for manufacturing a solar cell according to any one of claims 1 to 4, wherein a third coating material containing a silicon compound is coated so as to cover an upper portion of the first coating material and/or the second coating material, and the diffusion heat treatment is performed thereafter.

6. The method for manufacturing a solar cell according to any one of claims 1 to 5, wherein surfaces of the diffusion layers formed by the diffusion heat treatment is etched back.

7. The method for manufacturing a solar cell according to any one of claims 1 to 5, wherein surfaces of the diffusion layers formed by the diffusion heat treatment is oxidized.

8. The method for manufacturing a solar cell according to any one of claims 1 to 7, wherein the first diffusion layer and the second diffusion layer are formed in at least either side of a light-receiving surface (1a) and the backside (1b) of the light-receiving surface of the semiconductor substrate.

## Patentansprüche

1. Verfahren zur Herstellung einer Solarzelle (100) durch Bilden eines p-n-Übergangs in einem Halbleitersubstrat (1), das einen ersten Leitfähigkeitstyp aufweist, wobei mindestens: ein erstes Beschichtungsmaterial (8), das einen Dotierstoff des zweiten Leitfähigkeitstyps
und ein Mittel zum Verhindern der Streuung eines Dotierstoffes enthält, wobei das Mittel eine Siliziumverbindung umfasst, auf das den ersten Leitfähigkeitstyp aufweisende Halbleitersubstrat durch Siebdruck aufgebracht wird und ein zweites Beschichtungsmaterial (9), das einen Dotierstoff des zweiten Leitfähigkeitstyps enthält,
auf das den ersten Leitfähigkeitstyp aufweisende Halbleitersubstrat und das erste Beschichtungsmaterial durch Rotationsbeschichten aufgebracht wird, so dass das zweite Beschichtungsmaterial mit mindestens dem ersten Beschichtungsmaterial in Kontakt gebracht werden kann;
und eine erste Diffusionsschicht (2), die durch Auftragen des ersten Beschichtungsmaterials gebildet wird, und eine zweite Diffusionsschicht (3), die durch Auftragen des zweiten Beschichtungsmaterials gebildet wird, wobei die zweite Diffusionsschicht eine Leitfähigkeit aufweist, die niedriger ist als die der ersten Diffusionsschicht, gleichzeitig durch eine Diffusionswärmebehandlung gebildet werden, die zur Bildung des p-n-Übergangs führt, wobei ferner:
das erste Beschichtungsmaterial und das zweite Beschichtungsmaterial sich in mindestens einem unterscheiden von dem Prozentsatz eines Dotierstoffgehalts, einer Viskosität, den Gehalten des Mittels zur Verhinderung der Streuung eines Dotierstoffs und eines Mittels zur Verhinderung der Selbstdotierung, wobei das Mittel eine Siliziumverbindung umfasst, einem Dotierstofftyp und/oder Beschichtungsfilmdicken des ersten Beschichtungsmaterials und des zweite Beschichtungsmaterials während der Beschichtung; und
wobei der Prozentsatz des Dotierstoffgehalts des ersten Beschichtungsmaterials um das 4-fache oder mehr höher ist als der Prozentsatz des Dotierstoffgehalts des zweiten Beschichtungsmaterials.

2. Verfahren zur Herstellung einer Solarzelle nach Anspruch 1, wobei das zweite Beschichtungsmaterial ein Mittel zur Verhinderung von Selbstdotierung umfasst, wobei das Mittel eine Siliziumverbindung umfasst.

3. Verfahren zur Herstellung einer Solarzelle nach Anspruch 1 oder 2, wobei die Diffusionswärmebehandlung unter einer Atmosphäre einer Dampfphasendiffusionsquelle durchgeführt wird.

4. Verfahren zur Herstellung einer Solarzelle nach Anspruch 2 oder 3, wenn abhängig von Anspruch 2, wobei die Siliziumverbindung, die in dem Mittel zum Verhindern der Streuung eines Dotierstoffs umfasst ist, Si02 ist, und die Siliziumverbindung, die in dem Mittel zum Verhindern von Selbstdotierung umfasst ist, ein Vorläufer eines Siliziumoxids ist.

5. Verfahren zur Herstellung einer Solarzelle nach einem der Ansprüche 1 bis 4, wobei ein drittes Beschichtungsmaterial, das eine Siliziumverbindung enthält, aufgetragen wird, um einen oberen Abschnitt des ersten Beschichtungsmaterials und/oder des zweiten Beschichtungsmaterials abzudecken, und die Diffusionswärmebehandlung daraufhin durchgeführt wird.

6. Verfahren zur Herstellung einer Solarzelle nach einem der Ansprüche 1 bis 5, wobei Oberflächen der durch die Diffusionswärmebehandlung gebildeten Diffusionsschichten rückgeätzt werden.

7. Verfahren zur Herstellung einer Solarzelle nach einem der Ansprüche 1 bis 5, wobei Oberflächen der durch die Diffusionswärmebehandlung gebildeten Diffusionsschichten oxidiert werden.

8. Verfahren zur Herstellung einer Solarzelle nach einem der Ansprüche 1 bis 7, wobei die erste Diffusionsschicht und die zweite Diffusionsschicht in mindestens einer der Seiten einer Lichtempfangsfläche (1a) und der Rückseite (1b) der Lichtempfangsfläche des Halbleitersubstrats gebildet werden.

## Revendications

1. Procédé de fabrication d'une cellule solaire (100) par formation d'une jonction p-n dans un substrat semi-conducteur (1) présentant un premier type de conductivité, dans lequel, au moins : un premier matériau de revêtement (8) contenant un dopant du second type de conductivité et un agent pour empêcher la diffusion d'un dopant, ledit agent comprenant un composé de silicium, est appliqué par sérigraphie sur le substrat semi-conducteur présentant le premier type de conductivité, et un deuxième matériau de revêtement (9) contenant un dopant du second type de conductivité est appliqué sur le substrat semi-conducteur présentant le premier type de conductivité et le premier matériau de revêtement par revêtement par centrifugation de sorte que le deuxième matériau de revêtement puisse être mis en contact avec au moins le premier matériau de revêtement ; et une première couche de diffusion (2) formée par revêtement du premier matériau de revêtement, et une seconde couche de diffusion (3) formée par revêtement du deuxième matériau de revêtement, la seconde couche de diffusion ayant une conductivité inférieure à celle de la première couche de diffusion, sont simultanément formées par un traitement thermique de diffusion entraînant la formation de ladite jonction p-n, dans lequel en outre : le premier matériau de revêtement et le deuxième matériau de revêtement diffèrent l'un de l'autre au moins par le pourcentage de teneur en dopant, la viscosité, la teneur de l'agent pour empêcher la diffusion d'un dopant et d'un agent pour empêcher l'autodopage, ledit agent comprenant un composé de silicium, un type de dopant ; et/ou, des épaisseurs de film de revêtement du premier matériau de revêtement et du deuxième matériau de revêtement pendant le revêtement ; et
dans lequel le pourcentage de la teneur en dopant du premier matériau de revêtement est supérieur au pourcentage de la teneur en dopant du deuxième matériau de revêtement d'un facteur 4 ou plus.

2. Procédé de fabrication d'une cellule solaire selon la revendication 1, dans lequel le deuxième matériau de revêtement comprend un agent pour empêcher l'autodopage, ledit agent comprenant un composé de silicium.

3. Procédé de fabrication d'une cellule solaire selon la revendication 1 ou 2, dans lequel le traitement thermique de diffusion est effectué sous une atmosphère d'une source de diffusion de phase vapeur.

4. Procédé de fabrication d'une cellule solaire selon la revendication 2 ou la revendication 3 lorsqu'elle dépend de la revendication 2, dans lequel le composé de silicium inclus dans l'agent pour empêcher la diffusion d'un dopant est du SiO₂, et le composé du silicium inclus dans l'agent pour empêcher l'autodopage est un précurseur d'un oxyde de silicium.

5. Procédé de fabrication d'une cellule solaire selon l'une quelconque des revendications 1 à 4, dans lequel un troisième matériau de revêtement contenant un composé de silicium est appliqué de manière à recouvrir une partie supérieure du premier matériau de revêtement et/ou du deuxième matériau de revêtement, et le traitement thermique de diffusion est ensuite effectué.

6. Procédé de fabrication d'une cellule solaire selon l'une quelconque des revendications 1 à 5, dans lequel les surfaces des couches de diffusion formées par le traitement thermique de diffusion sont regravées.

7. Procédé de fabrication d'une cellule solaire selon l'une quelconque des revendications 1 à 5, dans lequel les surfaces des couches de diffusion formées par le traitement thermique de diffusion sont oxydées.

8. Procédé de fabrication d'une cellule solaire selon l'une quelconque des revendications 1 à 7, dans lequel la première couche de diffusion et la seconde couche de diffusion sont formées au moins de part et d'autre d'une surface de réception de lumière (1a) et de l'arrière (1b) de la surface de réception de la lumière du substrat semi-conducteur.
